# EUROPEAN PATENT APPLICATION

(11) **EP 4 704 517 A1**
(43) Date of publication of application: **04.03.2026**
(21) Application number: 24197276.9
(22) Date of filing: 29.08.2024
(51) Int. Cl.: H10D 30/66, H10D 12/00, H10D 62/10, H10D 62/13, H10D 62/17

(54) **SEMICONDUCTOR TRANSISTOR DEVICE INCLUDING TRENCH STRUCTURE**

(71) Applicant: Infineon Technologies Austria AG, 9500 Villach (AT)
(72) Inventor: POPESCU, Dan Horia, 81245 München (DE); POPESCU, Bogdan Vlad, 81245 München (DE)
(74) Representative: Müller Hoffmann & Partner

(57) **Abstract**

A semiconductor transistor device (100) is proposed. The semiconductor transistor device (100) includes a gate trench structure (102) extending from a first surface (1051) of a wide band gap semiconductor body (104), along a vertical direction (y), into the wide band gap semiconductor body (104). The gate trench structure (102) includes a gate trench dielectric (1021) and a gate trench electrode (1022). The semiconductor transistor device (100) further includes a body region (106) of a first conductivity type adjoining a first sidewall (1026) of the gate trench structure (102). A second sidewall (1027) of the gate trench structure (102) is opposite to the first sidewall (1026) along a first lateral direction (x1). The first lateral direction (x1) is perpendicular to a second lateral direction (x2). The semiconductor transistor device (100) includes an auxiliary structure (108) of the first conductivity type adjoining a bottom side (1028) of the gate trench structure (102). The semiconductor transistor device (100) further includes a drift structure (110) of a second conductivity type adjoining a bottom side (1061) of the body region (106). The drift structure (110) includes a drift layer (1105) arranged, along the vertical direction (y), between a bottom side (1081) of the auxiliary structure (108) and a second surface (1052) of the wide band gap semiconductor body (104). At a first position (p11) along the second lateral direction (x2), a first sub-region (1101) of the drift structure (110) extends from the bottom side (1061) of the body region (106) to the drift layer (1105). At a second position (p12) along the second lateral direction (x2), a second sub-region (1102) of the drift structure (110) extends from the bottom side (1061) of the body region (106) to a top side of a transverse sub-region (1081) of the auxiliary structure (108).

## Description

### TECHNICAL FIELD

The present disclosure is related to a semiconductor device, in particular to a semiconductor transistor device including a trench structure.

### BACKGROUND

Technology development of new generations of semiconductor devices, e.g. semiconductor transistor devices, aims at improving electric device characteristics and reducing costs by shrinking device geometries. Although costs may be reduced by shrinking device geometries, a variety of tradeoffs and challenges have to be met when increasing device functionalities per unit area. For example, a trade-off between area-specific on-state resistance, RₒₙxA, and reliability requirements influenced by, for example, short circuit withstand time, requires design optimization.

Thus, there is a need for an improved semiconductor transistor device.

### SUMMARY

An example of the present disclosure relates a semiconductor transistor device. The semiconductor transistor device includes a gate trench structure extending from a first surface of a wide band gap semiconductor body, along a vertical direction, into the wide band gap semiconductor body. The gate trench structure includes a gate trench dielectric and a gate trench electrode. The semiconductor transistor device further includes a body region of a first conductivity type adjoining a first sidewall of the gate trench structure. A second sidewall of the gate trench structure is opposite to the first sidewall along a first lateral direction. The first lateral direction is perpendicular to a second lateral direction. The semiconductor transistor device further includes an auxiliary structure of the first conductivity type adjoining a bottom side of the gate trench structure. The semiconductor transistor device includes a drift structure of a second conductivity type adjoining a bottom side of the body region. The drift structure includes a drift layer arranged, along the vertical direction, between a bottom side of the auxiliary structure and a second surface of the wide band gap semiconductor body. At a first position along the second lateral direction, a first sub-region of the drift structure extends from the bottom side of the body region to the drift layer. At a second position along the second lateral direction, a second sub-region of the drift structure extends from the bottom side of the body region to a top side of a transverse sub-region of the auxiliary structure.

A further example of the present disclosure relates to a method of manufacturing a semiconductor transistor device. The method includes forming a gate trench structure extending from a first surface of a wide band gap semiconductor body, along a vertical direction, into the wide band gap semiconductor body. The gate trench structure includes a gate trench dielectric and a gate trench electrode. The method further includes forming a body region of a first conductivity type adjoining a first sidewall of the gate trench structure. A second sidewall of the gate trench structure is opposite to the first sidewall along a first lateral direction. The first lateral direction is perpendicular to a second lateral direction. The method further includes forming an auxiliary structure of the first conductivity type adjoining a bottom side of the gate trench structure. The method further includes forming a drift structure of a second conductivity type adjoining a bottom side of the body region. The drift structure includes a drift layer arranged, along the vertical direction, between a bottom side of the auxiliary structure and a second surface of the wide band gap semiconductor body. At a first position along the second lateral direction, a first sub-region of the drift structure extends from the bottom side of the body region to the drift layer. At a second position along the second lateral direction, a second sub-region of the drift structure extends from the bottom side of the body region to a top side of a transverse sub-region of the auxiliary structure.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of semiconductor transistor devices and together with the description serve to explain principles of the examples. Further examples are described in the following detailed description and the claims.
Fig. 1 is an exemplary process illustration of manufacturing a semiconductor transistor device including an auxiliary structure.
Figs. 2A to 2C are schematic cross-sectional and top views for illustrating process features of forming an auxiliary structure.
Figs. 3A to 3E are schematic top and cross-sectional views for illustrating a configuration example of a semiconductor transistor device.
Figs. 4A to 4C are schematic top and cross-sectional views for illustrating a further configuration example of a semiconductor transistor device.

### DETAILED DESCRIPTION

In the following detailed description, reference is made to the accompanying drawings, which form a part hereof and in which are shown by way of illustrations specific examples of semiconductor transistor devices. It is to be understood that other examples may be utilized and structural or logical changes may be made without departing from the scope of the present disclosure. For example, features illustrated or described for one example can be used in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact is a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of the present disclosure relates to a semiconductor transistor device. The semiconductor transistor device includes a gate trench structure extending from a first surface of a wide band gap semiconductor body, along a vertical direction, into the wide band gap semiconductor body. The gate trench structure includes a gate trench dielectric and a gate trench electrode. The semiconductor transistor device further includes a body region of a first conductivity type adjoining a first sidewall of the gate trench structure. A second sidewall of the gate trench structure is opposite to the first sidewall along a first lateral direction. The first lateral direction is perpendicular to a second lateral direction. The semiconductor transistor device further includes an auxiliary structure of the first conductivity type adjoining a bottom side of the gate trench structure. The semiconductor transistor device includes a drift structure of a second conductivity type adjoining a bottom side of the body region. The drift structure includes a drift layer arranged, along the vertical direction, between a bottom side of the auxiliary structure and a second surface of the wide band gap semiconductor body. At a first position along the second lateral direction, a first sub-region of the drift structure extends from the bottom side of the body region to the drift layer. At a second position along the second lateral direction, a second sub-region of the drift structure extends from the bottom side of the body region to a top side of a transverse sub-region of the auxiliary structure.

The semiconductor transistor device may be an insulated gate field effect transistor (IGFET) such as a metal oxide semiconductor field effect transistor (MOSFET) or may be an insulated gate bipolar transistor (IGBT). The semiconductor transistor device may be part of an integrated circuit or may define a discrete semiconductor device or a semiconductor module, for example. For example, the semiconductor transistor device may be a vertical-channel semiconductor transistor device. In a vertical-channel semiconductor transistor device, a load current flow is between a first load electrode, e.g. a source electrode or an emitter electrode, over the first surface of the wide band gap semiconductor body and a second load electrode, e.g. a drain electrode or a collector electrode, over a second surface opposite to the first surface along the vertical direction. In the vertical-channel semiconductor transistor device, a load current may flow along the vertical direction perpendicular to the first and/or second surface. The semiconductor transistor device may be used in applications related to power transmission and distribution, automotive and transport, renewable energy, consumer electronics, and other industrial applications, for example.

The first surface may be a front surface or a top surface of the wide band gap semiconductor body, and the second surface may be a back surface or a rear surface of the wide band gap semiconductor body, for example. For example, the wide band gap semiconductor body may be attached to a lead frame via the second surface, for example. Over the first surface of the wide band gap semiconductor body, bond pads may be arranged and bond wires may be bonded on the bond pads, for example.

The semiconductor transistor device may be configured to conduct currents of more than 1A or more than 10 A or even more than 100 A. For example, the semiconductor transistor device may be designed as a transistor cell array of a plurality of transistor cells having a same layout. The transistor cell array may be a 1-dimensional or a 2-dimensional regular arrangement of the plurality of transistor cells. For example, the plurality of transistor cells of the transistor cell array may be electrically connected in parallel. For example, source or emitter regions of the plurality of transistor cells of the semiconductor transistor device cell array may be electrically connected together. Likewise, drain or collector regions of the plurality of transistor cells of the semiconductor transistor device cell array may be electrically connected together. For example, gate regions of the plurality of transistor cells of the semiconductor transistor device cell array may be electrically connected together. A transistor cell of the transistor cell array or a part thereof, e.g. the gate region, may be designed in the shape of a stripe, a polygon, a circle or an oval, for example.

A number of transistor cells of the transistor cell array may depend on the maximum load current, for example. For example, a number of transistor cells of the transistor cell array may be larger than 100, or larger than 1000, or even larger than 10000, for example. The semiconductor transistor device may be further configured to block voltages between the load electrodes, e.g. between drain and source of the MOSFET or between collector and emitter of the IGBT, of more than 60V, 100V, 400 V, 650V, 1.2kV, 1.7kV, 3.3kV, 4.5kV, 5.5kV, 6kV, 6.5kV, 10kV. The blocking voltage may correspond to a voltage class specified in a datasheet of the semiconductor transistor device, for example. The blocking voltage of the semiconductor transistor device may be adjusted by an impurity concentration and/or a vertical extension of a drift region in the semiconductor body. A doping concentration of the drift region may gradually or in steps increase or decrease with increasing distance to the first surface at least in portions of its vertical extension. According to other examples the impurity concentration in the drift region may be approximately uniform. When operating the semiconductor transistor device in voltage blocking mode, a space charge region may vertically extend partly or totally through the drift region depending on the blocking voltage applied to the semiconductor transistor device.

The semiconductor device may be based on a wide band gap semiconductor body from a crystalline wide band gap semiconductor material having a band gap larger than the band gap of silicon, i.e. larger than 1.12 eV. The wide band gap semiconductor material may have a hexagonal crystal lattice and may be silicon carbide (SiC), by way of example. For example, the semiconductor material may be 2H-SiC (SiC of the 2H polytype), 6H-SIC or 15R-SiC. According to an example, the semiconductor material is silicon carbide of the 4H polytype (4H-SiC). The semiconductor body may include or consist of a semiconductor substrate having none, one or more than one semiconductor layers, e.g. epitaxially grown layers, thereon. One of the semiconductor layers may be a doped semiconductor layer of a current spread layer, for example. As an alternative to a SiC semiconductor body, gallium arsenide (GaAs) or gallium nitride (GaN) may be used as a material of the wide band gap semiconductor body, for example.

For example, the gate trench dielectric may be formed by or may include an oxidation process, e.g. thermal oxidation process and/or oxide deposition process. Other dielectric materials may be used in addition to or as an alternative to the oxide. For example, high-k materials may be used. For example, the gate trench dielectric may include a high-k dielectric layer including at least one of Al₂O₃, ZrO₂, HfO₂, AIN, alumosilicate AlSiOx, silicon La- or Si-doped HfO₂, TiO₂, Y₂O₃, or Si₃N₄. For example, the gate trench dielectric may include at least a first dielectric sub-layer and a second dielectric sub-layer. The first dielectric sub-layer adjoining to a channel region may have a dielectric constant that is smaller than the dielectric constant of the high-k dielectric sub-layer, e.g. be equal to or larger than the dielectric constant of SiO₂. For example, the first dielectric layer may include at least one of SiO₂, AIN, or Si₃N₄, for example. The gate trench electrode may include one or more conductive material(s), e.g. metal, metal alloys, e.g. Cu, Au, AlCu, Ag, or alloys thereof, metal compounds, e.g. TiN, highly doped semiconductor material such as highly doped polycrystalline silicon. The one or more conductive materials may form a layer stack, for example. The gate trench electrode may be electrically connected to a gate pad via a gate interconnection structure such as a gate runner, for example. The gate pad/interconnection structure and, for example, a first load electrode pad, e.g. a source pad of the semiconductor transistor device may be part of a wiring area over the wide band gap semiconductor body.

The semiconductor transistor device including the transverse sub-region of the auxiliary structure may allow for an improved trade-off between the area-specific on-state resistance, RₒₙxA, and the short circuit withstand time by providing a 2D JFET structure, e.g. at least below a bottom side of the gate trench structure. The 2D JFET structure is based on the transverse sub-regions of the auxiliary structure and portions of the auxiliary structure adjoining a bottom side of the gate trench structure, wherein the portions link neighboring transverse sub-regions to one another. Since the 2D JFET structure is positioned below the gate trench structure, it may be combined with a vast variety of known cell layouts for achieving the improved trade-off between the area-specific on-state resistance, RₒₙxA, and the short circuit withstand time.

The 2D JFET structure may also allow for an improved shielding of the gate trench dielectric compared with 1D JFET structures.

For example, in a sectional plane defined by the vertical direction and the first lateral direction and taken at the second position along the second lateral direction, the second sub-region of the drift structure is bordered by a pn junction extending from a first position at the gate trench structure to a second position at the gate trench structure. For example, the first position at the gate trench structure may be located at the first sidewall of the gate trench structure. The second position of the gate trench structure may be located at the bottom side of the gate trench structure. In the sectional plane defined by the vertical direction and the first lateral direction and taken at the second position along the second lateral direction, the second sub-region of the drift structure is fully surrounded by the pn junction and part of the gate trench dielectric.

For example, at the second position along the second lateral direction, a vertical extent of the transverse sub-region of the auxiliary structure may be by more than a factor 2 larger than a vertical extent of the second sub-region of the drift structure.

For example, at the second position along the second lateral direction and at a vertical reference level in the center of the second sub-region of the drift structure, a doping concentration of the second conductivity type may be by more than one order of magnitude, e.g. between one and two orders of magnitude, larger than at the vertical reference level in the first sub-region of the drift structure at the first position along the second lateral direction.

For example, in a sectional plane defined by the first lateral direction and the second lateral direction and taken at a vertical reference level in the center of the transverse sub-region of the auxiliary structure, the first sub-region of the drift structure may be bordered by a pn junction running around the first sub-region of the drift structure. The doping concentration of the first conductivity type of the transverse sub-region may be by more than one order of magnitude larger than the doping concentration of the first sub-region for this pn junction. An area of the first conductivity type of the transverse sub-region may be by more than a factor two larger than the enclosed area of the first sub-region, for example.

For example, the auxiliary structure adjoins the first sidewall of the gate trench structure from the bottom side of the gate trench structure to the first surface. The auxiliary structure may be electrically connected to a first load electrode, e.g. a source electrode or an emitter electrode, via the first surface of the wide band gap semiconductor body, for example.

For example, the transverse sub-region of the auxiliary structure may interconnect portions of the auxiliary structure belonging to gate structures of neighboring transistor cells. For example, the transverse sub-region of the auxiliary structure may extend along the first lateral direction.

For example, the body region may extend along the first lateral direction and may adjoin a second sidewall of a second gate trench structure. For example, at least some of the gate trench structures may have a two-sided channel region by having the source region adjoining opposite sidewalls and having the body region adjoining opposite sidewalls of the respective gate trenches.

For example, the semiconductor transistor device may further include a third trench structure. The auxiliary structure may adjoin a sidewall of the third trench structure from a bottom side of the third trench structure to the first surface. The auxiliary structure at the third trench structure may provide an electric connection of the transverse sub-regions to the first load electrode over the first surface, for example.

Details with respect to structure, or function, or technical benefit of features described above with respect to a wide band gap semiconductor device such as a semiconductor transistor device likewise apply to the exemplary methods described further below. Processing the wide band gap semiconductor body may comprise one or more optional additional features corresponding to one or more aspects mentioned in connection with the proposed concept or one or more examples described above or below.

Some of the above and below examples may refer to a silicon carbide substrate. Alternatively, a wide band gap semiconductor substrate, e.g. a wide band gap wafer, may be processed, e.g. comprising a wide band gap semiconductor material different from silicon carbide. The wide band gap semiconductor wafer may have a band gap larger than the band gap of silicon (1.12 eV). For example, the wide band gap semiconductor wafer may be a silicon carbide (SiC) wafer, or gallium arsenide (GaAs) wafer.

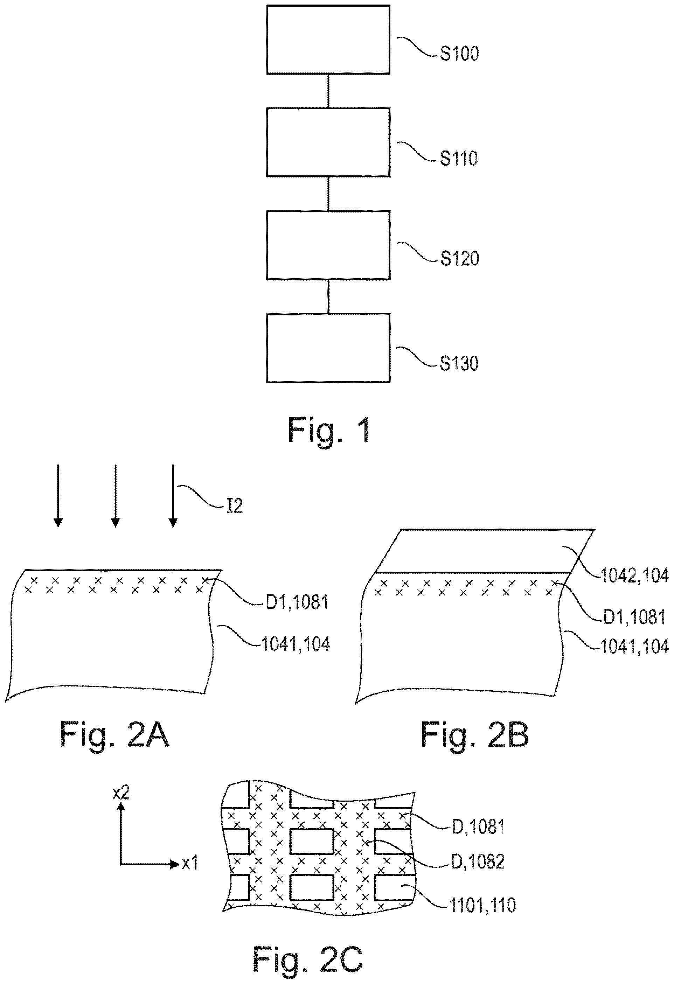

The process illustration of Fig. 1 refers to process features of forming a semiconductor transistor device.

Process feature S100 includes forming a gate trench structure extending from a first surface of a wide band gap semiconductor body, along a vertical direction, into the wide band gap semiconductor body, the gate trench structure including a gate trench dielectric and a gate trench electrode.

Process feature S110 includes forming a body region of a first conductivity type adjoining a first sidewall of the gate trench structure. A second sidewall of the gate trench structure is opposite to the first sidewall along a first lateral direction. The first lateral direction is perpendicular to a second lateral direction.

Process feature S120 includes forming an auxiliary structure of the first conductivity type adjoining a bottom side of the gate trench structure.

Process feature S130 includes forming a drift structure of a second conductivity type adjoining a bottom side of the body region. The drift structure includes a drift layer arranged, along the vertical direction, between a bottom side of the auxiliary structure and a second surface of the wide band gap semiconductor body. At a first position along the second lateral direction, a first sub-region of the drift structure extends from the bottom side of the body region to the drift layer. At a second position along the second lateral direction, a second sub-region of the drift structure extends from the bottom side of the body region to a top side of a transverse sub-region of the auxiliary structure.

It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, - processes, -operations or-steps, respectively. Such sub acts may be included and part of the disclosure of this single act unless explicitly excluded. For example, in the exemplary method described above, the gate trench structure may be formed after forming the body region and/or the source region and/or the auxiliary region or parts thereof. For example, the transverse sub-region of the auxiliary structure may be formed before etching a trench of the trench gate structure, and a further portion of the auxiliary structure may be formed after etching the trench and before forming the gate trench dielectric, e.g. by an ion implantation process through a sidewall of the trench.

The schematic cross-sectional views of Figs. 2A and 2B illustrate exemplary process features of forming the transverse sub-regions of the auxiliary region.

Referring to Fig. 2A, forming a transverse sub-region 1081 includes introducing dopants of the first conductivity type D1 into a wide band gap semiconductor substrate 1041, e.g. a SiC substrate, of the wide band gap semiconductor body 104, e.g. by an ion implantation process 12.

Thereafter and referring to Fig. 2B, a semiconductor layer 1042 is formed on the wide band gap semiconductor substrate 1041 by at least one epitaxial layer deposition process. For example, the body region and the trench structure may be formed in the semiconductor layer 1042.

As illustrated in the schematic top view of Fig. 2C, the transverse sub-region 1081 may be arranged as parallel stripes extending along a first lateral direction x1 and spaced from one another along a second lateral direction x2. The parallel stripes are interconnected by interconnection links 1082. The transverse sub-regions 1081 and the interconnection links 1082 define a grid shape.

The transverse sub-regions 1081 and the interconnection links 1082 may be defined by at least one ion implantation process using an ion implantation mask. One or more further ion implantation processes may be carried out using another ion implantation mask for introducing dopants of the second conductivity type into those regions of the wide band gap semiconductor substrate 1041 that are laterally surrounded by the transverse sub-regions 1081 and the interconnections links 1082. Thereby, a doping concentration profile of a first sub-region 1101 of a drift structure 110 may be adjusted and a 2D JFET is provided since the channel current has to pass those regions of the wide band gap semiconductor substrate 1041 that are laterally surrounded by the transverse sub-regions 1081 and the interconnections links 1082.

For example, forming the first sub-region of the drift structure may include a plurality of first ion implantation processes having different ion implantation energies. This may allow for adjusting a vertical doping concentration profile of the first sub-region of the drift structure, for example. Thereby, guidance of a channel current toward a drain or collector electrode at a second surface of the wide band gap semiconductor substrate may be optimized with respect to its contribution to the area-specific on-state resistance, RₒₙxA.

For example, forming the second sub-region of the drift structure may include a second ion implantation process having a larger ion implantation dose than any of the plurality of first ion implantation processes. The second ion implantation process may introduce dopants of the second conductivity type into the semiconductor layer 1042 of Fig. 2B from a top side of the semiconductor layer 1042. After carrying out the second ion implantation process, a thickness of the semiconductor layer 1042 may be further increased by at least one more epitaxial layer deposition process. For example, dopants of a body and/or source region may be introduced into the semiconductor layer after carrying out the at least one more epitaxial layer deposition process.

For example, forming the auxiliary structure may include at least one upstream ion implantation process carried out before etching a trench of the gate trench structure, and further includes at least one downstream ion implantation process carried out after etching the trench of the gate trench structure. For example, the at least one upstream ion implantation process carried out before etching the trench of the gate trench structure may include the process described with reference to Fig. 2A. The at least one downstream ion implantation process may include an ion implantation process through a sidewall of the trench of the gate trench structure before forming the gate trench dielectric and the gate trench electrode.

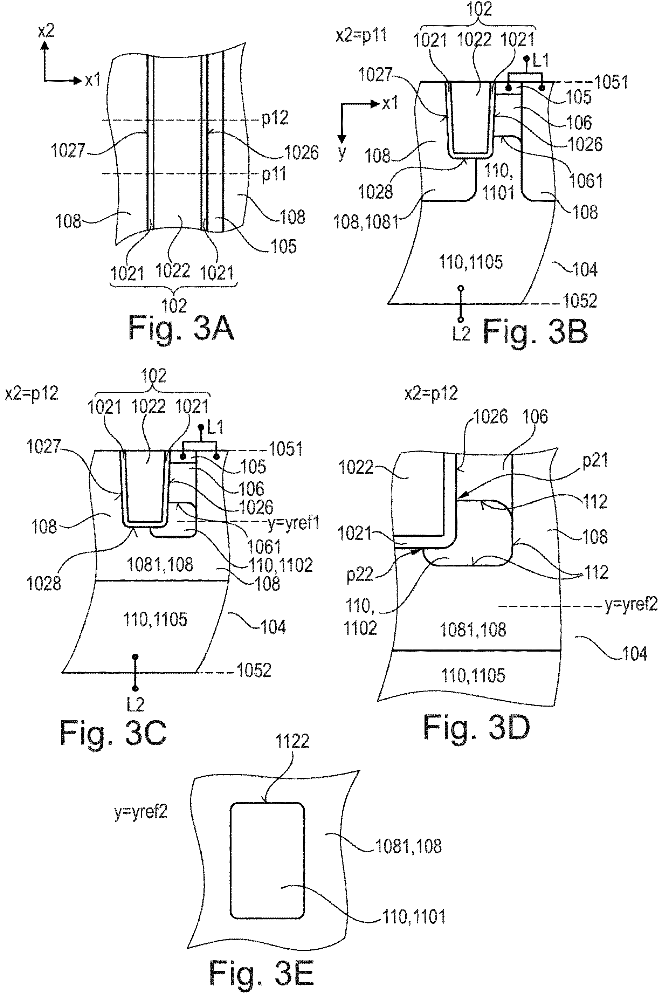

A configuration example of a semiconductor transistor device 100 is illustrated in the schematic top and cross-sectional views of Figs. 3A to 3E. The semiconductor transistor device 100 is exemplified as a MOSFET.

Referring to the schematic top view of Fig. 3A, the semiconductor transistor device 100 includes a gate trench structure 102. The gate trench structure 102 includes a gate trench dielectric 1021 and a gate trench electrode 1022 and extends along the second lateral direction x2. A source region 105 of the second conductivity type adjoins a first sidewall 1026 of the gate trench structure 102. An auxiliary structure 108 of the first conductivity type adjoins a second sidewall 1027 of the gate trench structure 102.

The schematic cross-sectional view of Fig. 3B is taken at a first position p11 along the second lateral direction x2 of Fig. 3A.

The gate trench structure 102 extends from a first surface 1051 of the wide band gap semiconductor body 104, along a vertical direction y, into the wide band gap semiconductor body 104.

A body region 106 of a first conductivity type adjoins the first sidewall 1026 of the gate trench structure 102. Along the first lateral direction x1, the body region 106 is arranged between and confined by the first sidewall 1026 of the gate trench structure 102 and the auxiliary structure 108. The body region 106 is electrically coupled via the auxiliary structure 108 to a first load electrode L1 over the first surface 1051 of the wide band gap semiconductor body 104. Moreover, the source region 105 is electrically coupled to the first load electrode L1 over the first surface 1051 of the wide band gap semiconductor body 104. Along the vertical direction y, the body region 106 is arranged between and confined by the source region 105 and the first sub-region 1101 of the drift structure 110 of the second conductivity type. The first sub-region 1101 turns into a drift layer 1105 that is electrically coupled to a second load electrode L2, e.g. a drain electrode or a collector electrode, via a second surface 1052 of the wide band gap semiconductor body 104.

The schematic cross-sectional view of Fig. 3C is taken at a second position p12 along the second lateral direction x2 of Fig. 3A.

At the second position p12, a second sub-region 1102 of the drift structure 110 extends from the bottom side 1061 of the body region 106 to a top side of the transverse sub-region 1081 of the auxiliary structure 108. A channel current entering the second sub-region 1102 of the drift structure 110 is conducted to the drift layer 1105 via the first sub-region 1101 of the drift structure 110.

An enlarged section around a bottom side 1028 of the gate trench structure 102 of Fig. 3C is illustrated in Fig. 3D.

Referring to Fig. 3D, in a sectional plane defined by the vertical direction y and the first lateral direction x1 and taken at the second position p12 along the second lateral direction x2 of Fig. 3A, the second sub-region 1102 of the drift structure 110 is bordered by a pn junction 112 extending from a first position p21 at the gate trench structure 102 to a second position p22 at the gate trench structure 102. Thus, in the sectional plane defined by the vertical direction y and the first lateral direction x1 and taken at the second position p12 along the second lateral direction x2 of Fig. 3A, the second sub-region 1102 of the drift structure 110 is fully surrounded by the pn junction 112 and part of the gate trench dielectric 1021.

At a vertical reference level yref1 in the center of the second sub-region 1102 of the drift structure 110, a doping concentration of the second conductivity type may be by more than one order of magnitude larger than, see. e.g. Fig. 3B, at the vertical reference level yref1 in the first sub-region 1101 of the drift structure 110 at the first position p11 along the second lateral direction x2 of Fig. 3A.

The schematic view of Fig. 3E refers to a sectional plane defined by the first lateral direction x1 and the second lateral direction x2 and is taken at a vertical reference level yref2, see e.g. Fig. 3D, in the center of the transverse sub-region 1081 of the auxiliary structure 108.

The first sub-region 1101 of the drift structure 110 is bordered by a pn junction 1122 running around the first sub-region 1101 of the drift structure 110. The first sub-region 1101 may be fully surrounded by the transverse sub-regions 1081 and the interconnection links 1082 as described with reference to Figs. 2A to 2C, for example.

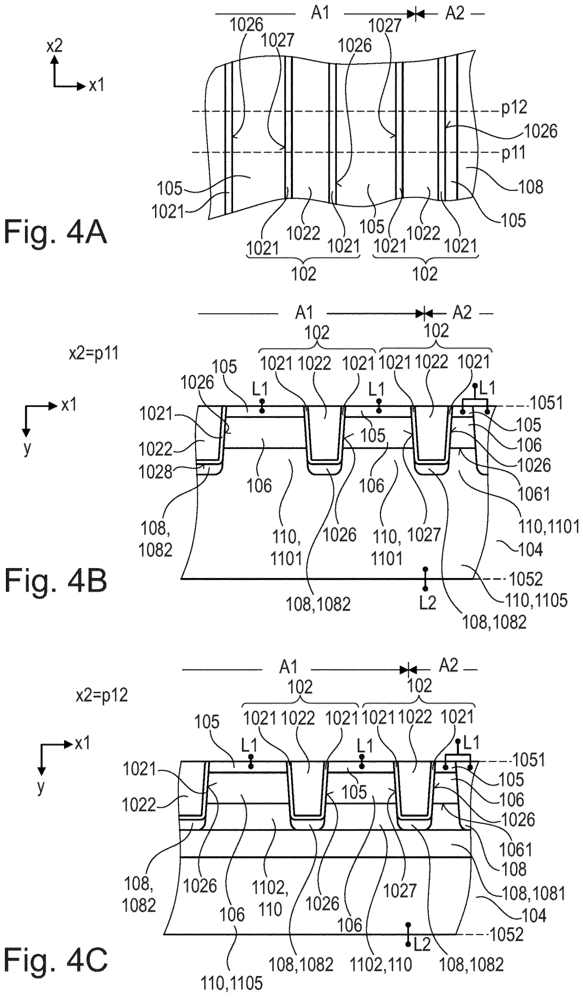

A further configuration example of a semiconductor transistor device 100 is illustrated in the schematic top and cross-sectional views of Figs. 4A to 4C. The semiconductor transistor device 100 is exemplified as a MOSFET.

Referring to the schematic top view of Fig. 4A, the semiconductor transistor device 100 includes a gate trench structure 102. The gate trench structure 102 includes a gate trench dielectric 1021 and a gate trench electrode 1022 and extends along the second lateral direction x2. A source region 105 of the second conductivity type adjoins first and second sidewalls 1026, 1027 of the neighboring gate trench structures 102 in a first portion A1 of the semiconductor transistor device 100. An auxiliary structure 108 of the first conductivity type extends up to the first surface 1051 of the wide band gap semiconductor body 104 in a second portion A2 of the semiconductor transistor device 100

The schematic cross-sectional view of Fig. 4B is taken at a first position p11 along the second lateral direction x2 of Fig. 4A.

In the second portion A2, each of the body region 106 and the source region 105 is laterally arranged between the gate trench structure 102 and the auxiliary structure 108.

In the first and second portions A1, A2, the source region 105 may be interrupted along the second lateral direction x2 by contact portions of the first conductivity type for enabling an electric connection of the body regions 106 to the first load electrode L1 over the first surface 1051 (not illustrated in Fig. 4B).

Interconnection links 1082 of the auxiliary structure 108 adjoin a bottom side 1028 of the gate trench structure 102. Along the vertical direction y, the body region 106 is arranged between and confined by the source region 105 and the first sub-region 1101 of the drift structure 110 of the second conductivity type. The first sub-region 1101 turns into the drift layer 1105 that is electrically coupled to the second load electrode L2, e.g. drain or collector electrode, via the second surface 1052 of the wide band gap semiconductor body 104.

The schematic cross-sectional view of Fig. 4C is taken at the second position p12 along the second lateral direction x2 of Fig. 4A.

At the second position p12 along the second lateral direction x2 of Fig. 4A, the second sub-region 1102 of the drift structure 110 extends from the bottom side 1061 of the body region 106 to a top side of the transverse sub-region 1081 of the auxiliary structure 108. A channel current entering the second sub-region 1102 of the drift structure 110 is conducted to the drift layer 1105 via the first sub-region 1101 of the drift structure 110. The transverse sub-region 1081 in the first and second portions A1, A2 is electrically coupled to the first load electrode L1 via the auxiliary structure 108 extending to the first surface 1051 in second first portion A2 of the semiconductor transistor device 100.

The aspects and features mentioned and described together with one or more of the previously described examples and figures, may as well be combined with one or more of the other examples in order to replace a like feature of the other example or in order to additionally introduce the feature to the other example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor transistor device (100), comprising:
a gate trench structure (102) extending from a first surface (1051) of a wide band gap semiconductor body (104), along a vertical direction (y), into the wide band gap semiconductor body (104), the gate trench structure (102) including a gate trench dielectric (1021) and a gate trench electrode (1022);
a body region (106) of a first conductivity type adjoining a first sidewall (1026) of the gate trench structure (102), wherein a second sidewall (1027) of the gate trench structure (102) is opposite to the first sidewall (1026) along a first lateral direction (x1), the first lateral direction (x1) being perpendicular to a second lateral direction (x2);
an auxiliary structure (108) of the first conductivity type adjoining a bottom side (1028) of the gate trench structure (102),
a drift structure (110) of a second conductivity type adjoining a bottom side (1061) of the body region (106), the drift structure (110) comprising a drift layer (1105) arranged, along the vertical direction (y), between a bottom side (1081) of the auxiliary structure (108) and a second surface (1052) of the wide band gap semiconductor body (104); wherein
at a first position (p11) along the second lateral direction (x2), a first sub-region (1101) of the drift structure (110) extends from the bottom side (1061) of the body region (106) to the drift layer (1105), and
at a second position (p12) along the second lateral direction (x2), a second sub-region (1102) of the drift structure (110) extends from the bottom side (1061) of the body region (106) to a top side of a transverse sub-region (1081) of the auxiliary structure (108).

2. The semiconductor transistor device (100) of the preceding claim, wherein, in a sectional plane defined by the vertical direction (y) and the first lateral direction (x1) and taken at the second position (p12) along the second lateral direction (x2), the second sub-region (1102) of the drift structure (110) is bordered by a pn junction (112) extending from a first position (p21) at the gate trench structure (102) to a second position (p22) at the gate trench structure (102).

3. The semiconductor transistor device (100) of the preceding claim, wherein the first position (p21) at the gate trench structure (102) is located at the first sidewall (1026) of the gate trench structure (102), and the second position (p22) of the gate trench structure (102) is located at the bottom side (1028) of the gate trench structure (102).

4. The semiconductor transistor device (100) of any of the preceding claims, wherein, at the second position (p12) along the second lateral direction (x2), a vertical extent of the transverse sub-region (1081) of the auxiliary structure (108) is by more than a factor 2 larger than a vertical extent of the second sub-region (1102) of the drift structure (110).

5. The semiconductor transistor device (100) of any of the preceding claims, wherein, at the second position (p12) along the second lateral direction (x2) and at a vertical reference level (yref1) in the center of the second sub-region (1102) of the drift structure (110), a doping concentration of the second conductivity type is between one and two orders of magnitude larger than at the vertical reference level (yref1) in the first sub-region (1101) of the drift structure (110) at the first position (p11) along the second lateral direction (x2).

6. The semiconductor transistor device (100) of any of the preceding claims, wherein, in a sectional plane defined by the first lateral direction (x1) and the second lateral direction (x2) and taken at a vertical reference level (yref2) in the center of the transverse sub-region (1081) of the auxiliary structure (108), the first sub-region (1101) of the drift structure (110) is bordered by a pn junction (1122) running around the first sub-region (1101) of the drift structure (110).

7. The semiconductor transistor device (100) of the preceding claim, wherein the auxiliary structure (108) adjoins the first sidewall (1026) of the gate trench structure (102) from the bottom side (1028) of the gate trench structure (102) to the first surface (1051).

8. The semiconductor transistor device (100) of any of the preceding claims, wherein the transverse sub-region (1081) of the auxiliary structure (108) interconnects portions of the auxiliary structure belonging to gate structures of neighboring transistor cells.

9. The semiconductor transistor device (100) of claim 1, wherein the body region (106) extends along the first lateral direction (x1) and adjoins a second sidewall of a second gate trench structure.

10. The semiconductor transistor device (100) of claim 1 or 9, further comprising a third trench structure, wherein the auxiliary structure (108) adjoins a sidewall of the third trench structure from a bottom side of the third trench structure to the first surface (1051).

11. A method of manufacturing a semiconductor transistor device (100), the method comprising:
forming a gate trench structure (102) extending from a first surface (1051) of a wide band gap semiconductor body (104), along a vertical direction (y), into the wide band gap semiconductor body (104), the gate trench structure (102) including a gate trench dielectric (1021) and a gate trench electrode (1022);
forming a body region (106) of a first conductivity type adjoining a first sidewall (1026) of the gate trench structure (102), wherein a second sidewall (1027) of the gate trench structure (102) is opposite to the first sidewall (1026) along a first lateral direction (x1), the first lateral direction (x1) being perpendicular to a second lateral direction (x2);
forming an auxiliary structure (108) of the first conductivity type adjoining a bottom side (1028) of the gate trench structure (102),
forming a drift structure (110) of a second conductivity type adjoining a bottom side (1061) of the body region (106), the drift structure (110) comprising a drift layer (1105) arranged, along the vertical direction (y), between a bottom side (1081) of the auxiliary structure (108) and a second surface (1052) of the wide band gap semiconductor body (104); wherein
at a first position (p11) along the second lateral direction (x2), a first sub-region (1101) of the drift structure (110) extends from the bottom side (1061) of the body region (106) to the drift layer (1105), and
at a second position (p12) along the second lateral direction (x2), a second sub-region (1102) of the drift structure (110) extends from the bottom side (1061) of the body region (106) to a top side of a transverse sub-region (1081) of the auxiliary structure (108).

12. The method of the preceding claim, wherein
forming the transverse sub-region (1081) includes introducing dopants of the first conductivity type (D1) into a wide band gap semiconductor substrate (1041) of the wide band gap semiconductor body (104); and thereafter
forming a semiconductor layer (1042) on the wide band gap semiconductor substrate (1041) by at least one epitaxial layer deposition process.

13. The method of any of the two preceding claims, wherein
forming the first sub-region (1101) of the drift structure (110) includes a plurality of first ion implantation processes having different ion implantation energies.

14. The method of the preceding claim, wherein
forming the second sub-region (1102) of the drift structure (110) includes a second ion implantation process having a larger ion implantation dose than any of the plurality of first ion implantation processes.

15. The method of any of the three preceding claims, wherein
forming the auxiliary structure (108) includes at least one upstream ion implantation process carried out before etching a trench of the gate trench structure (102), and further includes at least one downstream ion implantation process carried out after etching the trench of the gate trench structure (102).
